# EUROPÄISCHE PATENTANMELDUNG

(11) **EP 0 899 550 A1**
(43) Veröffentlichungstag der Anmeldung: **03.03.1999**
(21) Anmeldenummer: 98202758.3
(22) Anmeldetag: 18.08.1998
(51) Int. Cl.: G01K 7/22, H01C 7/04, H01C 1/142

(54) **Schaltungsanordnung mit einem SMD-Bauelement, insbesondere Temperatursensor und Verfahren zur Herstellung eines Temperatursensors**

(30) Priorität: 23.08.1997 DE 19736855
(71) Anmelder: Philips Patentverwaltung GmbH, 22335 Hamburg (DE); Koninklijke Philips Electronics N.V., 5621 BA Eindhoven (NL)
(72) Erfinder: Groen, W.-A., Dr., Röntgenstrasse 24, 22335 Hamburg (DE); Sillen, Ir.V.R.C.M.J., Röntgenstrasse 24, 22335 Hamburg (DE)
(74) Vertreter: Hartmann, Heinrich, Dipl.-Ing.

(57) **Zusammenfassung**

Die Erfindung betrifft eine Schaltungsanordnung mit einem SMD-Bauelement (1), insbesondere einen Temperatursensor mit einem Thermistorelement (1) mit zwei elektrisch leitenden Kontakten (2a, 2b), welche mit jeweils einer auf einem Substrat (4) aufgebrachten Leiterbahn (3a, 3b) leitend verbunden sind. Eine feste mechanische, als auch eine gute elektrisch leitende Verbindung zwischen dem SMD-Bauelement und den Leiterbahnen wird dabei dadurch erreicht, daß die Kontakte (2a, 2b) aus jeweils einer die Verbindung mit den Leiterbahnen (3a, 3b) schaffenden Metall-Glas-Schicht (6) gebildet sind und daß die Metall-Glas-Schicht (6) durch Erhitzen eines Glaspartikel enthaltenden Metalls bis zum Schmelzen oder Erweichen der Glaspartikel hergestellt ist. Die Erfindung betrifft außerdem auch ein Verfahren zur Herstellung eines Temperatursensors und zur Herstellung einer solchen Verbindung.

## Beschreibung

Die Erfindung betrifft eine Schaltungsanordnung mit einem SMD-Bauelement, insbesondere einen Temperatursensor mit einem Thermistorelement mit zwei elektrisch leitenden Kontakten, welche mit jeweils einer auf einem Substrat aufgebrachten Leiterbahn leitend verbunden sind. Die Erfindung betrifft weiterhin ein Verfahren zur Herstellung eines Temperatursensors sowie ein Verfahren zur Herstellung einer elektrisch leitenden Verbindung zwischen einem Kontakt eines SMD-Bauelements und einer Leiterbahn auf einem Substrat.

Ein derartiger Temperatursensor ist aus der JP-A 4-91401 bekannt. Das Thermistorelement ist dort als Dünnfilmelement auf der Oberfläche eines Aluminiumträgerelementes aufgebracht. Zu beiden Seiten des Thermistorelements ist jeweils eine Filmelektrode auf dem Trägerelement angeordnet. Zur Herstellung elektrisch leitender Verbindungen zwischen den Elektroden und Leiterbahnen auf einem Substrat ist durch das Trägerelement und durch die Elektroden jeweils eine Bohrung vorgesehen, durch die ein elektrisch leitendes Element geführt ist zur Verbindung zwischen der Elektrode und der Leiterbahn.

Der Erfindung liegt die Aufgabe zugrunde, eine eingangs genannte Schaltungsanordnung mit einem SMD-Bauelement mit verbesserten Kontakten, einen einfach herzustellenden Temperatursensor sowie ein einfaches Herstellungsverfahren für einen Temperatursensor anzugeben.

Die Aufgaben betreffend die Schaltungsanordnung und den Temperatursensor werden dadurch gelöst, daß die Kontakte aus jeweils einer die Verbindung mit den Leiterbahnen schaffenden Metall-Glas-Schicht gebildet sind und daß die Metall-Glas-Schicht durch Erhitzen eines Glaspartikel enthaltenden Metalls bis zum Schmelzen oder Erweichen der Glaspartikel hergestellt ist.

Die als Metall-Glas-Schicht ausgebildeten Kontakte stellen sowohl eine elektrisch leitende Verbindung (aufgrund des Metallanteils) als auch eine feste mechanische Verbindung (aufgrund des aus den Glaspartikeln durch Schmelzen oder Erweichen und anschließendes Abkühlen entstandenen Glases) mit den Leiterbahnen her. Aufwendige Bohrungen, wie sie bei dem bekannten Temperatursensor vorgesehen sind, um die Isolierstrecke zwischen dem Thermistorelement und den Lötstellen auf den Leiterbahnen möglichst groß zu machen, sind bei der erfindungsgemäßen Schaltungsanordnung und bei dem erfindungsgemäßen Temperatursensor nicht erforderlich, da das Glas der Metall-Glas-Schicht bei den zu messenden Temperaturen nicht schmelzen und somit die mechanische Verbindung nicht zerstört werden kann.

In einer Ausgestaltung der Erfindung ist vorgesehen, daß die Kontakte Silber, Kupfer, Gold, Platin oder eine Legierung mit einem solchen Material, z.B. eine Platinlegierung enthalten. Die Auswahl des Metalls ist abhängig von der Anwendung, insbesondere von den zu messenden Temperaturen. Für hohe Temperaturen bis ca. 1100°C eignet sich vor allem Platin. Gleiches gilt für eine weitere Ausgestaltung der Erfindung, gemäß der die Leiterbahnen aus Silber, Kupfer, Gold, Platin oder aus einer Legierung mit einem solchen Material bestehen.

Bevorzugt ist in einer Weiterbildung der Erfindung vorgesehen, daß das Thermistorelement aus halbleitendem keramischem Material besteht. Besonders eine Halbleiterkeramik aus einem Mischkristalloxyd der Seltenerdmetalle ist besonders hochtemperatur- und langzeitstabil und eignet sich für einen Temperatursensor zur Messung hoher Temperaturen bis 1100°C. Derartige Thermistorelemente sind in der europäischen Patentanmeldung Nr. 97201494.8 beschrieben. Aus Halbleiterkeramik bestehende Thermistorelemente haben auch den Vorteil, daß sie ein großes Ausgangssignal liefern und daß deshalb die benötigte Schaltungsanordnung zur Verarbeitung der Signale verhältnismäßig einfach, verglichen mit der bei einem herkömmlichen Thermoelement benötigten Schaltungsanordnung, aufgebaut sein kann.

Um zu verhindern, daß die Metallkontakte bei höheren Temperaturen oxydieren und um ggf. die mechanische Verbindung zwischen dem Thermistorelement und dem Substrat zu verstärken, ist in einer Ausgestaltung der Erfindung vorgesehen, daß das Thermistorelement und/oder die Kontakte von einer aus Glas und/oder Keramikmaterial bestehenden Schicht überdeckt sind. Diese kann hergestellt werden, indem das bereits mit den Leiterbahnen verbundene Thermistorelement in eine Paste mit Glas- und/oder Keramikpulver eingetaucht und anschließend in einem Ofen erhitzt wird, wobei die Temperatur niedriger ist als die Schmelztemperatur des Glases der die Kontakte bildenden Metall-Glas-Schichten. Dabei schmilzt das Glas in der Paste bzw. sintert das Keramikpulver zusammen und eine feste Schicht entsteht.

Die Aufgabe betreffend ein Verfahren zur Herstellung eines Temperatursensors wird dadurch gelöst, daß zur Bildung von Kontakten auf zwei Endflächen eines Thermistorelements Metallpaste mit eingebrachten Glaspartikeln aufgebracht wird, daß die Kontakte mit jeweils einer auf einem Substrat aufgebrachten Leiterbahn in Berührung gebracht werden und daß die Kontakte bis zum Schmelzen oder Erweichen der Glaspartikel erhitzt und anschließend abgekühlt werden. Dieses Verfahren eignet sich sowohl zur Herstellung von Temperatursensoren mit negativem Temperaturkoeffizient (NTC's), deren Widerstand mit steigender Temperatur abfällt, als auch zur Herstellung von Temperatursensoren mit positivem Temperaturkoeffizient (PTC's), deren Widerstand mit steigender Temperatur ansteigt. Bevorzugt erfolgt die Erhitzung der Kontakte in einem Ofen, es ist jedoch auch denkbar, die Kontakte mittels eines Heißgasstrahl oder mit anderen Mitteln zu erhitzen, ohne dabei das Thermistorelement zu schädigen.

Die Erfindung betrifft überdies auch ein Verfahren zur Herstellung einer elektrisch leitenden Verbindung zwischen einem Kontakt eines SMD-Bauelements und einer Leiterbahn auf einem Substrat, das dadurch gekennzeichnet ist, daß zur Bildung des Kontakts auf eine Oberfläche des SMD-Bauelements Metallpaste mit eingebrachten Glaspartikeln aufgebracht wird, daß der Kontakt mit der Leiterbahn in Berührung gebracht wird und daß der Kontakt bis zum Schmelzen oder Erweichen der Glaspartikel erhitzt und anschließend abgekühlt wird. So können beispielsweise herkömmliche SMD-Widerstände oder SMD-Kondensatoren auf einem Substrat mechanisch fest aufgebracht werden.

Die erfindungsgemäßen Temperatursensoren eignen sich besonders zur Messung hoher Temperaturen, insbesondere im Bereich zwischen 500°C und 1100°C, beispielsweise zur Messung der Abgastemperatur oder Katalysatortemperatur bei Fahrzeugen oder zur Temperaturregelung bei der Motorsteuerung. Aber auch für industrielle Abgastemperaturmessungen sind die erfindungsgemäßen Temperatursensoren geeignet.

Anhand der Zeichnung soll die Erfindung naher erläutert werden. Es zeigen:
Fig. 1 einen erfindungsgemäßen Temperatursensor und
Fig. 2 eine vergrößerte Darstellung der Metall-Glas-Schicht.

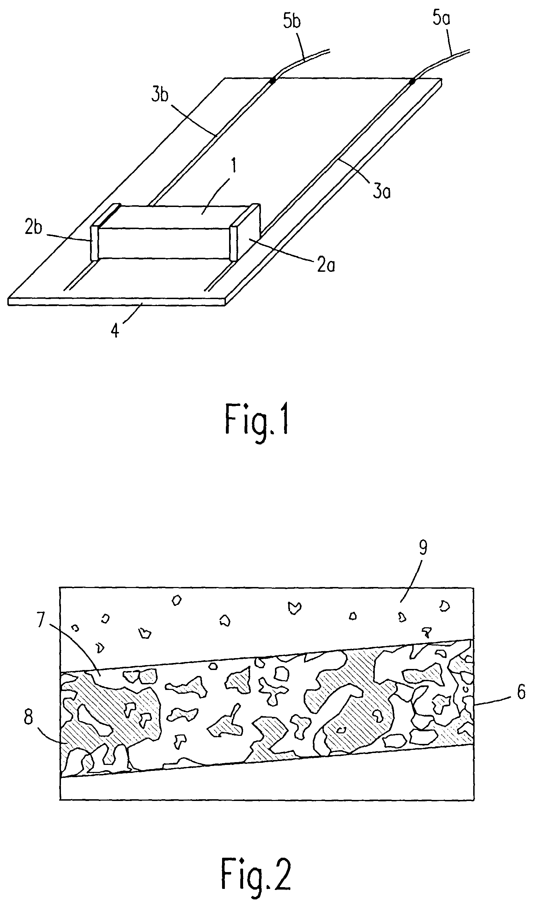

In Fig. 1 ist ein quaderförmig ausgestaltetes Thermistorelement 1 dargestellt, das an zwei seitlichen Endflächen jeweils einen elektrisch leitenden Kontakt 2a bzw. 2b aufweist. Die Kontakte 2a, 2b sind elektrisch leitend und mechanisch fest mit jeweils einer Leiterbahn 3a, 3b verbunden, die auf einem Substrat 4, beispielsweise photolithographisch, aufgebracht sind. In einem Abstand von dem Thermistorelement 1 an einem Ende des Substrats 4, dem kalten Ende (im Gegensatz zu dem heißen Ende des Substrats 4, an dem das Thermistorelement 1 angeordnet ist) sind an die Leiterbahnen 3a, 3b Anschlußdrähte 5a, 5b angelötet.

Zur Herstellung der Kontakte 2a, 2b wird das Thermistorelement zunächst mit den Endflächen in eine Paste getaucht, die im wesentlichen aus Platin mit zugesetzten Glaspartikeln (etwa 1 bis 10 Gewichtsprozent Glas, z.B. in Pulverform mit Partikelgrößen von 1 bis 10 µm) besteht. Außerdem enthält die Paste geeignete Binde- und Lösungsmittel. Das Platin ist ebenfalls in Pulverform in der Paste vorhanden. Das Thermistorelement 1 wird nun derart auf das Substrat 4 aufgesetzt, daß sich die Kontakte 2a, 2b und die Leiterbahnen 3a, 3b berühren. Unter starker Erhitzung verbrennen nun zunächst die Binde- und Lösungsmittel und die Glaspartikel beginnen je nach Glasart und Temperatur zu schmelzen bzw. zu erweichen (z.B. bei 1300°C). Das in Pulverform vorhandene Platin sintert nun in dem geschmolzenen Glas zusammen und bildet, nachdem das Glas beim anschließenden Abkühlen wieder erhärtet ist, zusammen mit diesem eine feste Metall-Glas-Schicht, die den Kontakt 2a bzw. 2b bildet. Dadurch wird eine feste mechanische Verbindung (Adhäsion) zwischen den Kontakten 2a, 2b und den Leiterbahnen 3a, 3b erreicht wird, die aufgrund des überwiegenden Platinanteils in der Metall-Glas-Schicht elektrisch leitend ist.

Die Metall-Glas-Schicht 6 auf der Keramik 9 des Thermistorelements 1 ist vergrößert in Fig. 2 gezeigt. Dort ist das erhärtete Glas 8 zu erkennen, in dem das zusammengesinterte Platin 7 verteilt angeordnet ist. Das erhärtete Glas 8 bewirkt auch die feste Verbindung mit der Keramik 9.

Die Temperatur, bei der das Glas schmilzt bzw. erweicht, ist abhängig von der gewählten Glassorte und muß natürlich höher gewählt sein als die größte von dem Temperatursensor zu messende Temperatur. Der Anteil der Glaspartikel in der Paste darf einerseits nicht zu gering ausfallen, da ansonsten keine ausreichend feste Verbindung zwischen den Kontakten 2a, 2b und den Leiterbahnen 3a, 3b erreicht werden könnte. Andererseits darf der Anteil der Glaspartikel auch nicht zu groß sein, da ansonsten keine oder nur eine schlechte elektrisch leitende Verbindung zwischen dem Thermistorelement 1 und den Kontakten 2a, 2b bestehen würde. Als Substrat 4 eignet sich vor allem Aluminiumoxid oder auch BeO, MgO, AlN oder andere Materialien, die gegen hohe Temperaturen beständig sind.

## Patentansprüche

1. Schaltungsanordnung mit einem SMD-Bauelement (1) mit zwei elektrisch leitenden Kontakten (2a, 2b), welche mit jeweils einer auf einem Substrat (4) aufgebrachten Leiterbahn (3a, 3b) leitend verbunden sind,
dadurch gekennzeichnet, daß die Kontakte (2a, 2b) aus jeweils einer die Verbindung mit den Leiterbahnen (3a, 3b) schaffenden Metall-Glas-Schicht (6) gebildet sind und daß die Metall-Glas-Schicht (6) durch Erhitzen eines Glaspartikel enthaltenden Metalls bis zum Schmelzen oder Erweichen der Glaspartikel hergestellt ist.

2. Schaltungsanordnung nach Anspruch 1,
dadurch gekennzeichnet, daß die Kontakte (2a, 2b) Silber, Kupfer, Gold, Platin oder eine Legierung mit einem solchen Material enthalten.

3. Schaltungsanordnung nach Anspruch 1,
dadurch gekennzeichnet, daß die Leiterbahnen (3a, 3b) aus Silber, Kupfer, Gold, Platin oder einer Legierung mit einem solchen Material bestehen.

4. Temperatursensor mit einem Thermistorelement (1) mit zwei elektrisch leitenden Kontakten (2a, 2b), welche mit jeweils einer auf einem Substrat (4) aufgebrachten Leiterbahn (3a, 3b) leitend verbunden sind,
dadurch gekennzeichnet, daß die Kontakte (2a, 2b) aus jeweils einer die Verbindung mit den Leiterbahnen (3a, 3b) schaffenden Metall-Glas-Schicht (6) gebildet sind und daß die Metall-Glas-Schicht (6) durch Erhitzen eines Glaspartikel enthaltenden Metalls bis zum Schmelzen oder Erweichen der Glaspartikel hergestellt ist.

5. Temperatursensor nach Anspruch 4,
dadurch gekennzeichnet, daß das Themistorelement (1) aus halbleitendem keramischem Material, insbesondere aus einem Mischkristalloxyd der Seltenerdmetalle besteht.

6. Temperatursensor nach Anspruch 4,
dadurch gekennzeichnet, daß das Thermistorelement (1) und/oder die Kontakte (2a, 2b) von einer aus Glas und/oder Keramikmaterial bestehenden Schicht überdeckt ist.

7. Verfahren zur Herstellung eines Temperatursensors,
dadurch gekennzeichnet, daß zur Bildung von Kontakten (2a, 2b) auf zwei Endflächen eines Thermistorelements (1) Metallpaste mit eingebrachten Glaspartikeln aufgebracht wird, daß die Kontakte (2a, 2b) mit jeweils einer auf einem Substrat (4) aufgebrachten Leiterbahn (3a, 3b) in Berührung gebracht werden und daß die Kontakte (2a, 2b) bis zum Schmelzen oder Erweichen der Glaspartikel erhitzt und anschließend abgekühlt werden.

8. Verfahren zur Herstellung einer elektrisch leitenden Verbindung zwischen einem Kontakt (2a, 2b) eines SMD-Bauelements (1) und einer Leiterbahn (3a, 3b) auf einem Substrat (4),
dadurch gekennzeichnet, daß zur Bildung des Kontakts (2a, 2b) auf eine Oberfläche des SMD-Bauelements (1) Metallpaste mit eingebrachten Glaspartikeln aufgebracht wird, daß der Kontakt (2a, 2b) mit der Leiterbahn (3a, 3b) in Berührung gebracht wird und daß der Kontakt (2a, 2b) bis zum Schmelzen oder Erweichen der Glaspartikel erhitzt und anschließend abgekühlt wird.

9. Verwendung des Temperatursensors nach Anspruch 4 zur Messung hoher Temperaturen, insbesondere im Bereich zwischen 500°C und 1100°C, beispielsweise zur Messung der Abgastemperatur oder der Katalysatortemperatur bei Fahrzeugen.
